# EUROPÄISCHE PATENTANMELDUNG

(11) **EP 3 591 090 A1**
(43) Veröffentlichungstag der Anmeldung: **08.01.2020**
(21) Anmeldenummer: 18182052.3
(22) Anmeldetag: 05.07.2018
(51) Int. Cl.: C23C 14/08, C03C 17/245, C23C 14/34, C23C 14/46, G02B 1/10, H01J 37/317

(54) **VERFAHREN UND VORRICHTUNG ZUR SPUTTER-DEPOSITION BESCHICHTUNG VON EINEM OBJEKT BELIEBIGER GEOMETRIE**

(71) Anmelder: Justus-Liebig-Universität Gießen, 35390 Gießen (DE)
(72) Erfinder: Becker, Martin, 35625 Hüttenberg (DE); Chatterjee, Sangam, 35037 Marburg (DE); Holste, Kristof, 35390 Gießen (DE); Klar, Peter, 35392 Gießen (DE)
(74) Vertreter: Stumpf, Peter

(57) **Zusammenfassung**

Die Erfindung betrifft ein Verfahren und eine Vorrichtung zur Beschichtung mindestens einem Objekt beliebiger Geometrie mittels Sputter-Deposition. Es umfasst dabei verschiedene Schritte. Zunächst erfolgt in einem Schritt A die Erfassung der Form der zu beschichtenden Oberfläche und die Übermittlung der resultierenden Oberflächendaten an ein Auswertemittel. Anschließend erfolgt in einem Schritt B die Eingabe des Zielschichtdickenprofils und Übermittlung des Zielschichtdickenprofils an ein Auswertemittel. Dann erfolgt in einem Schritt C die Berechnung eines Bestrahlungsplans mit dem notwendigen Gesamtstrahlprofil mittels eines Auswertemittels, sodass die resultierende Massendichteverteilung des Beschichtungsmaterials das Zielschichtdickenprofil aus Schritt B aus den in Schritt A erfassten Oberflächendaten ergibt. Weiterhin erfolgt dabei die Übermittlung des Bestrahlungsplans an ein Steuerungsmittel. Danach geschieht in einem Schritt D die Einstellung von wenigstens zwei Ionenquellen zur Erzeugung des notwendigen Gesamtstrahlprofils zur Durchführung des Bestrahlungsplans aus Schritt C von mindestens einem Target. Abschließend erfolgt in einem Schritt E die Durchführung der Beschichtung der zu beschichtenden Oberfläche ausgehend vom Bestrahlungsplan aus Schritt C und der Einstellung der Ionenquellen aus Schritt D.

## Beschreibung

Die vorliegende Erfindung betrifft ein Verfahren und eine Vorrichtung zur Sputter-Deposition-Beschichtung mindestens eines Objekt beliebiger Geometrie insbesondere von Freiformen.

### Beschreibung und Einleitung des allgemeinen Gebietes der Erfindung

Beim Beschuss einer Oberfläche mit Ionen können, abhängig von den verwendeten Ionen und ihrer kinetischen Energie, verschiedene Effekte auftreten:
- Die Ionen kondensieren auf dem beschossenen Substrat und bilden dort eine Schicht. Dies wird als lonenstrahldeposition bezeichnet. Dies geschieht vorwiegend bei kleinen Energien.
- Material vom beschossenen Target (Kathode) wird als Sekundäremissionskeule (Sekundärplume) abgetragen. Dies wird als Sputtern bezeichnet. Dies geschieht vorwiegend bei mittleren Energien.
- Die Ionen werden in das Targetmaterial eingebaut und gehen dort gegebenenfalls eine chemische Verbindung ein. Dieser Effekt wird (reaktive) lonenimplantation genannt. Dies geschieht vorwiegend bei hohen Energien.

Ist ein Materialabtrag beabsichtigt, so müssen die Ionen dafür eine gewisse Mindestenergie besitzen. Das auftreffende Ion überträgt seinen Impuls auf Atome des Targets des beschossenen Materials, die dann in einer Stoßkaskade weitere Kollisionen auslösen. Nach mehreren Kollisionen hat ein Teil der Targetatome einen Impuls, der vom Targetinneren fortweist. Befindet sich ein solches Atom in der Nähe der Oberfläche und hat es eine hinreichend hohe Energie, kann es das Target verlassen.

lonenstrahl-Sputterdeposition und lonenstrahlverdichten sind als Methoden der Dünnschichttechnologie prinzipiell aus der Literatur bekannt.

In lonenstrahl-Sputter-Systemen werden die einfallenden Ionen in einer Ionenquelle erzeugt, während sich das Target in einem lokal von der lonenquelle getrennten Bereich der Prozesskammer befindet. Zur lonenstrahl-Sputterdeposition bringt man in die Nähe des Targets zusätzlich ein Substrat, sodass die herausgeschlagenen Targetatome auf diesem kondensieren und eine Schicht bilden können. Der Gasdruck in der Prozesskammer muss in diesem Prozess gering sein (Vakuum), damit die Targetatome das Substrat erreichen, ohne mit anderen Gasteilchen zusammenzustoßen. Das heißt, die mittlere freie Weglänge der Gasteilchen muss mindestens dem Abstand des Targets zum Substrat entsprechen. Bei einem Abstand von ca. 30 cm sollte der Gasdruck daher nicht größer als ca. 2×10⁻⁴ mbar (Hochvakuum) betragen, andernfalls sind schlechtere Schichteigenschaften die Folge. Da die Substrate nicht der Entladung oder dem Strahl direkt ausgesetzt sind, werden sie nicht stark erwärmt. Daher kann nahezu jedes Material, das gesputtert werden kann, auf temperaturempfindlichen Substraten abgeschieden werden.

Besonders aufwändig ist die gleichmäßige Beschichtung von nicht-planen Oberflächen jeglicher Art und jeglichen Materials, sogenannten Freiformen. Insbesondere im Prozess der Glasherstellung ist ein spezieller Herstellungsprozess unter dem Namen 'Freiform' oder auch häufig 'Freeform' bekannt. Hierbei werden die Glasflächen vollkommen frei definiert. Glasdesign, das Vorbereiten des Produkts und die Herstellung und Ausmessung der Glasflächen zählen dabei zum Gesamtverfahren. Derart hergestellte Optiken weisen häufig eine sehr komplexe Geometrie auf, garantieren jedoch z. B. bei Brillenoptiken ein individuell angepasstes Sehen. Im beschriebenen Verfahren und genannter Vorrichtung zur lonenstrahl-Sputter-Beschichtung stellen Freiform-Optiken jedoch nur ein mögliches Anwendungsfeld unter vielen dar. So können Objekte beliebiger Geometrie bestehend aus verschiedensten Materialien beschichtet werden, wenn das als Schicht aufzubringende Material als Target oder in Kombination mit den der lonenquelle zugeführten gasförmigen Komponenten prozessierbar ist.

Die homogene Beschichtung von Freiformen, insbesondere auch von Freiform-Optiken stellt eine große Herausforderung dar. Beispielsweise hängen die Funktion der optischen Beschichtung sowie auch der Farbeindruck stark von den Schichtdicken ab. Eine Freiform homogen und konform mit Schichten konstanter Dicke zu belegen ist schwierig aufgrund von Abschattungseffekten sowie der inhärenten Variation der Neigung der Oberflächennormalen zur Richtung der Quelle (von der das aufzubringende Material kommt) sowie der Variation des Abstandes von Freiformoberfläche zur Quelle.

### Stand der Technik

Mit gängigen Beschichtungssystemen ist es heute nicht möglich, routinemäßig in Produktionslinien nichtplane Oberflächen, d. h. Freiformen und insbesondere auch Freiform-Optiken, konform mit Multischichten zu versehen. In der Praxis wird derzeit auf hochkomplexe und damit mechanisch sehr anfällige Planetengetriebe im Vakuum zurückgegriffen, um einzelne Freiformen zu beschichten, d.h. Konformität wird dadurch erzielt, dass das zu beschichtende Objekt während des Beschichtungsprozesses bewegt werden muss. Der hier beschriebene Ansatz setzt auf die Möglichkeit, die Dichte des Beschichtungsmaterials im Beschichtungsprozess über der Objektoberfläche gezielt direkt einzustellen, dadurch müssen weder Objekt noch Quellen während des Beschichtungsprozesses bewegt werden. Ein Online-Betrieb ist so mit großer Reproduzierbarkeit möglich. Dadurch wird eine routinemäßige Abscheidung von Multischicht-Systemen in einer Qualität möglich, die die Vorteile solcher Multischicht-Systeme auf Freiform-Optiken voll zum Tragen bringt, was deren Anwendungsmöglichkeiten stark erweitert.

### Aufgabe

Aufgabe der vorliegenden Erfindung ist es, eine Beschichtung von einem Objekt beliebiger Geometrie (Freiformen) mit einem bestimmten Schichtdickenprofil insbesondere mit einer homogenen Beschichtung mittels Sputter-Deposition zu ermöglichen.

### Lösung der Aufgabe

Die Aufgabe wird durch das Verfahren mit den Merkmalen des Hauptanspruchs und mit einer Vorrichtung mit den Merkmalen des Anspruchs 2 gelöst. Vorteilhafte Weiterbildungen der Erfindung sind in den Unteransprüchen beschrieben.

### Verfahren:

Das erfindungsgemäße Verfahren umfasst die folgenden Schritte:
- A Erfassung der Form der zu beschichtenden Oberfläche und Übermittlung der resultierenden Oberflächendaten an ein Auswertemittel
- B Eingabe des Zielschichtdickenprofils und Übermittlung des Zielschichtdickenprofils an ein Auswertemittel
- C Berechnung eines Bestrahlungsplans mit dem notwendigen Gesamtstrahlprofil mittels eines Auswertemittels, sodass die resultierende Massendichteverteilung des Beschichtungsmaterials das Zielschichtdickenprofil aus Schritt B aus den in Schritt A erfassten Oberflächendaten ergibt und Übermittlung des Bestrahlungsplans an ein Steuerungsmittel
- D Einstellung von wenigstens zwei Ionenquellen zur Erzeugung des notwendigen Gesamtstrahlprofils zur Durchführung des Bestrahlungsplans aus Schritt C.
- E Durchführung der Beschichtung der zu beschichtenden Oberfläche ausgehend vom Bestrahlungsplan aus Schritt C und der Einstellung der Ionenquellen aus Schritt D.

### A Erfassung der Form der zu beschichtenden Oberfläche

In einem ersten Schritt A erfolgt die Erfassung der Form und vorzugsweise des Materials der zu beschichtenden Oberfläche. Typische Formen können rotationssymmetrische Objekte mit sphärischen, ellipsoiden, hyperbolischen oder parabolischen Querschnitten ("Kegelschnitte") sein, wie sie beispielsweise in Kameraoptiken, Mikroskopoptiken oder in Laserspiegeln zum Einsatz kommen, aber auch Objekte niedrigerer Symmetrie wie typische Brillengläser oder generelle nichtuniforme rationale B-Spline Oberflächen ("NURBS"). Die zu beschichtende Freiform muss aus einem Feststoff bestehen, z. B. Glas, Kunststoff, Halbleiter oder Metall und kann auch magnetische Eigenschaften aufweisen.

Für Erfassung der Form der zu beschichtenden Oberfläche gibt es mehrere Möglichkeiten. Eine erste Möglichkeit ist es, die Oberfläche mit einem optischen Erfassungsmittel (z. B. einer Kamera) zu erfassen und die Bilddaten dann an ein Auswertemittel zur weiteren Verarbeitung zu übertragen.

Eine weitere Möglichkeit ist, dass Oberflächendaten, die bereits in einer Datenbank hinterlegt sind, aus dieser Datenbank an ein Auswertemittel zur weiteren Verarbeitung übertragen werden. Dies ist insbesondere vorteilhaft, wenn mehrere Objekte mit gleichem Oberflächenprofil beschichtet werden sollen. Weiterhin muss hierbei nicht für jedes einzelne zu beschichtende Objekt ein Erfassungsmittel verwendet werden.

Anschließend erfolgt die Übermittlung der resultierenden Oberflächendaten an ein Auswertemittel.

Die Oberflächendaten umfassen die Daten der Geometrie des zu beschichtenden Objektes. Weiterhin können sie noch Daten wie chemische Zusammensetzung, Temperatur, Feuchte der Oberfläche umfassen. Die Erfassung weiterer Parameter ist möglich.

### B Eingabe des gewünschten Zielschichtdickenprofils

In einem zweiten Schritt B erfolgt die Eingabe des Zielschichtdickenprofils. Die Daten des Zielschichtdickenprofils umfassen im Wesentlichen die Information darüber, welche Schichtdicke an welcher Stelle der Oberfläche erzielt werden soll. Die zu deponierenden Schichtdicken liegen in dem für Sputter-Deposition üblichen Dickenbereich von einigen wenigen 10 Nanometern bis zu mehreren 10 Mikrometern. Das bedeutet diese liegen zwischen 10nm bis 100µm. Die dabei zu erzielenden Schichtdicken auch von einzelnen Schichten eines Multischichtsystems lassen sich auf wenige Nanometer genau kontrollieren. Dieser Grad an Kontrolle erlaubt es beispielweise bei optischen Beschichtungen, Oberflächenrauigkeiten kleiner als ein Zehntel der Wellenlänge des zu manipulierenden Lichts routinemäßig zu erzielen, was essentiell ist, um die gewünschte Funktion der Beschichtung (z. B. einer Antireflexionsschicht) zu gewährleisten und/oder beispielsweise auch unerwünschte Farbeindrücke aufgrund von Schichtdickenvariationen zu vermeiden.

Für die Eingabe des Zielschichtdickenprofils gibt es zwei Möglichkeiten. Eine erste Möglichkeit ist es, die Daten des Schichtdickenprofils über ein Eingabemittel einzugeben und an ein Auswertemittel zur weiteren Verarbeitung zu übertragen. Eine weitere Möglichkeit ist, Daten des Schichtdickenprofils, die in einer Datenbank hinterlegt sind, aus dieser Datenbank an ein Auswertemittel zur weiteren Verarbeitung zu übertragen. Dies ist insbesondere vorteilhaft, wenn mehrere Objekte mit gleichem Schichtdickenprofil beschichtet werden sollen. Weiterhin muss hierbei nicht für jedes einzelne zu beschichtende Objekt ein separates Eingabemittel verwendet werden.

Anschließend erfolgt die Übermittlung des Zielschichtdickenprofils an ein Auswertemittel.

### C Berechnung des notwendigen Gesamtstrahlprofils

In einem dritten Schritt C erfolgt die Berechnung des Bestrahlungsplans mit dem notwendigen Gesamtstrahlprofil, zur Erzielung des Zielschichtdickenprofils aus Schritt B.

Hierbei werden zunächst die Daten der möglichen Strahlprofile und daraus resultierender Sekundärplumes von wenigstens zwei Ionenquellen, die bereits in einer Datenbank hinterlegt sind, aus einer Datenbank an ein Auswertemittel zur weiteren Verarbeitung übertragen.

Anschließend wird durch das Auswertemittel berechnet, wie mehrere Ionenquellen angesteuert werden müssen, so dass deren freigesetzte Ionen Atome des Targetmaterials so abtragen, dass die resultierende Überlagerung der Sekundärplumes auf der Freiform die resultierende Massendichteverteilung des Beschichtungsmaterials des Zielschichtdickenprofils aus Schritt B ergibt.

Das Resultat ist ein Bestrahlungsplan. Dieser umfasst die Daten darüber, wann und wie lange jede lonenquelle mit welchem Strahl-Profil Ionen emittieren soll. Weiterhin umfasst der Bestrahlungsplan das Gesamtstrahlprofil. Das Gesamtstrahlprofil ist die Gesamtheit der überlagerten einzelnen Strahlprofile aller verwendeten Ionenquellen. Anschließend erfolgt die Übertragung des Bestrahlungsplans aus Schritt C an ein Steuerungsmittel.

### D Einstellung von wenigstens zwei Ionenquellen zur Erzeugung des notwendigen Gesamtstrahlprofils

Im folgenden Schritt D erfolgt die Einstellung von wenigstens zwei Ionenquellen zur Erzeugung des notwendigen Gesamtstrahlprofils zur Durchführung des Bestrahlungsplans aus Schritt C.

Die Strahlprofile der typischerweise eingesetzten Gitter-lonenquellen (Hochfrequenz-lonenquelle oder Kaufman-Quelle) lassen sich durch die Lochstrukturen ihrer Extraktionsgitter gezielt einstellen.

### E Durchführung der Beschichtung

Abschließend erfolgt in Schritt E die Durchführung der Beschichtung ausgehend vom Bestrahlungsplan aus Schritt C und der Einstellung der Ionenquellen aus Schritt D. Dabei werden mehrere Ionenquellen mit unterschiedlichen Strahlprofilen bei der lonenstrahl-Sputterdeposition so einsetzt, dass sich deren Sekundärplumes (die vom Targetmaterial ausgehen) so überlagern, dass die resultierende Massendichteverteilung des Beschichtungsmaterials über der Freiform das gewünschte Beschichtungsprofil, z. B. eine homogene konforme Beschichtung, gewährleistet und die Effekte der gekrümmten Oberflächen ausgleicht.

Die Überlagerung der Sekundärplumes zu der für eine konforme Beschichtung erforderlichen Massendichteverteilung über der Freiform kann auf verschiedene Weisen im Sinne einer "Reihenentwicklung" nach einem vollständigen System von Basis-Funktionen realisiert werden. Dies geschieht in Analogie zu einer Fourier-Reihe oder einer Entwicklung nach Kugelflächenfunktionen.

Die Ionenquellen können zur Realisierung der konformen Beschichtung sowohl seriell als auch parallel betrieben werden.

### Vorrichtung:

Die erfindungsgemäße Vorrichtung 10 zur Beschichtung von Objekten beliebiger Geometrie insbesondere von Freiformen mittels Sputter-Deposition umfasst verschiedene Bauelemente.

Zunächst umfasst die erfindungsgemäße Vorrichtung wenigstens zwei Ionenquellen 21,22 zur Bereitstellung der für die Beschichtung notwendigen Ionen. Hierbei handelt es sich um übliche Ionenquellen. Von einer lonenquelle werden Teilchen auf mindestens ein Target 70 hin beschleunigt, wo sie Atome des Targetmaterials herausschlagen. Diese herausgeschlagenen Targetatome bilden die gerichteten Sekundärplumes, welche zur Erzeugung der Sputter-Deposition Beschichtung dienen.

In der bevorzugten Ausbildung der erfindungsgemäßen Vorrichtung werden dabei Gitter-Ionenquellen verwendet. Diese kann man in zwei Unterkategorien unterteilen. So gibt es zum einen Gitterionenquellen, welche auf die Ausbildung hoch fokussierter lonenstrahlen optimiert sind und damit zwecks Behandlung großflächiger Substrate bewegt werden müssen. Hoch fokussiert heißt der Fokusdurchmesser ist kleiner als 1 cm²· Weiterhin gibt es, Breitstrahlionenquellen. Letztere werden zur großflächigen Modifikation von Materialien (Sputtern, Ätzen etc.) eingesetzt. Großflächig bedeutet, dass Flächen von wenigstens 100 cm² bestrahlt werden können.

Die Ionenquellen 21, 22 weisen jeweils einen Gaseinlass auf. Durch diesen Gaseinlass kann das notwendige inerte Prozessgas und/oder Gasgemisch aus inertem Prozessgas und Reaktivgas in die lonenquelle einleitet werden. Als Inertgas wird häufig Argon eingesetzt werden, aber auch der Einsatz anderer Edelgase ist möglich. Bei Gasgemischen wird oft, aber nicht notwendig, ein reaktives Gas wie Sauerstoff oder Stickstoff zugesetzt, so ist es beispielweise möglich, ausgehend von metallischen Targets oxydische oder nitridische Beschichtungen herzustellen. Weiterhin umfasst jede lonenquelle ein Gefäß aus elektrisch isolierendem Material, in welches inerte Prozessgas und/oder Gasgemisch eingeleitet werden kann. Das Gefäß aus elektrisch isolierendem Material ist dabei so ausgebildet, dass die lonisationsprozesse beispielsweise durch Einkoppeln eines hochfrequenten Wechselfeldes im Inneren des Gefäßes initiiert werden können um das Prozessgas und/oder Gasgemisch zu ionisieren. Das elektrisch isolierende Gefäß besitzt weiterhin eine offene Seite, an welche ein Beschleunigungsgittersystem (mindestens zwei hintereinander liegende gitterförmige Elektroden mit Extraktionskanälen) anschließt. Das Beschleunigungsgittersystem ist so ausgebildet, dass die aus den lonisationsprozessen resultierenden Ionen durch thermische Diffusion aus dem Plasma in einen der Extraktionskanäle eintreten und in Richtung des Targets 70 extrahiert werden können und im elektrischen Feld des Beschleunigungsgittersystems Energie aufnehmen. Diese primär freigesetzten Ionen bilden dabei sogenannte Primärplums. Typische Ionenenergien des Primärstrahls liegen im Bereich von 10 eV bis zu 10 keV. Das von diesen Primärplumes der Ionenquellen 21,22 getroffene Target 70 besteht aus einer chemischen Verbindung (z. B. oxydische Materialien wie SiO₂, TiO₂ oder Nitride wie GaN) oder dem puren Element (z. B. Metalle wie Titan, Nickel, Kupfer, Silicium), das zur Erzeugung der gewünschten Beschichtung dient. Aus dem Target herausgeschlagene Targetatome bilden die Sekundärplumes 21a, 22a. Diese Sekundärplumes 21a, 22a sind ausgerichtet und dienen der Erzeugung der gewünschten Beschichtung auf dem zu beschichteten Objekt 100.

Weiterhin umfasst die erfindungsmäße Vorrichtung 10 ein Auswertemittel 30. Dieses dient dazu, die Oberflächendaten aus Schritt A des erfindungsgemäßen Verfahrens und die Daten des Schichtdickenprofils aus Schritt B des erfindungsgemäßen Verfahrens zusammen mit den Daten über mögliche Strahlprofile der wenigstens zwei Ionenquellen 21,22 zu empfangen und (zwischen) zu speichern. Weiterhin dient das Auswertemittel 30 dazu, aus diesen Daten im Rahmen des Schrittes C einen Bestrahlungsplan zu erstellen und diesen an eine Steuereinheit 40 zu senden.

Als Auswertemittel dient dabei ein Gerät zur elektronischen Datenverarbeitung z. B. ein in die Vorrichtung integrierter programmierbarer Mikroprozessor. Das Auswertemittel 30 ist weiterhin so ausgebildet, dass es die Ergebnisse eines Erfassungsmittels 50 und/oder eines Eingabemittels 60 auswerten und die Resultate an ein Steuerungsmittel 40 übermitteln kann.

Die Oberflächendaten sind dabei in einer internen Datenbank des Auswertemittels 30 hinterlegt oder werden durch einen Datenaustausch mit einer externen Datenbank beispielsweise über ein Netzwerk oder durch einen Datenaustausch mit einem Erfassungsmittel 50 bezogen. Dazu weist das Auswertemittel 30 vorzugsweise eine Schnittstelle zum elektronischen Datenaustausch (engl. electronic data interchange, EDI) auf.

Die Datenübertragung kann über eine feste Datenleitung oder drahtlos beispielsweise über eine Funkverbindung erfolgen.

Die Daten des Schichtdickenprofils und die Daten über mögliche Strahlprofile und resultierende Sekundärplumes der wenigstens zwei Ionenquellen 21,22 sind dabei in einer internen Datenbank des Auswertemittels 30 hinterlegt oder werden durch einen Datenaustausch mit einer externen Datenbank beispielsweise über ein Netzwerk oder durch einen Datenaustausch mit einem Eingabemittel 60 bezogen.

Weiterhin umfasst die erfindungsgemäße Vorrichtung 10 ein Steuerungsmittel 40 zur Einstellung der Strahlprofile für die wenigstens zwei Ionenquellen mit Gittersystem 21,22.

Das Steuerungsmittel 40 dient dabei insbesondere der Modifikation der Sekundärplumes der wenigstens zwei Ionenquellen mit Gittersystem 21,22.

Zum Steuerungsmittel 40 können beispielsweise zusätzlich gehören: Blenden zum Abblenden des Sekundärplumes, Magnete zur Formung des Sekundärplumes, Stellmotoren zum Bewegen einer oder mehrerer lonenquelle und oder des zu beschichtenden Objektes um deren Abstand zu einander zu verändern und so die Form und die Dichte des auftreffendes Sekundärplumes anpassen. Die Verwendung weiterer Bauelemente ist möglich.

In einer zweiten Ausführungsform umfasst die erfindungsgemäße Vorrichtung 10 weiterhin noch ein Erfassungsmittel 50. Das Erfassungsmittel 50 dient dazu, die Oberfläche des zu beschichtenden Objektes mit dem Erfassungsmittel (z. B. einer Kamera) zu erfassen und die Oberflächendaten dann an das Auswertemittel 30 zur weiteren Verarbeitung zu übertragen.

In einer dritten Ausführungsform umfasst die erfindungsgemäße Vorrichtung 10 weiterhin noch ein Eingabemittel 60. Das Eingabemittel 60 dient dazu, die Daten des Schichtdickenprofils in Verfahrensschritt B und/oder und die Daten über mögliche Strahlprofile der wenigstens zwei Ionenquellen 21,22 einzugeben und an das Auswertemittel 30 zur weiteren Verarbeitung zu übertragen. Beim Eingabemittel 60 kann es sich um eine Tastatur oder um eine grafische Benutzeroberfläche oder auch grafische Benutzerschnittstelle (Abk. GUI von englisch *graphical user interface*) handeln.

Ein Ausführungsbeispiel wäre die konforme Beschichtung eines Brillenglases mit einer Antireflexionsschicht. Mindestens zwei Ionenquellen werden mit Gittern, die auf die Brillenparameter, sphärischer Parameter und zylindrische Parameter zugeschnitten sind, betrieben. Die Primärplumes der Ionenquellen, die alle mit Argon betrieben werden, sind auf das entsprechende Metalloxid-Target gerichtet, so dass ihre Sekundärplumes die Oberseite des asphärischen Linsenkörpers aus Glas oder Kunststoff gleichmäßig beschichten.

Ein weiteres Ausführungsbeispiel wäre die Beschichtung eines konkaven Hochleistungsspiegels mit einem Multischichtsystem aus Hafniumoxid und Titanoxid wie es zum Beispiel in Peta-Watt-Lasersystemen zum Einsatz kommen kann. Die Primärplumes mindestens zweier Ionenquellen mit unterschiedlichen Gittersätzen, die beide mit einem Argon-Sauerstoffgemisch betrieben werden, sind auf die Targetposition gerichtet, so dass ihre Sekundärplumes die Oberfläche des konkaven Spiegelkörper aus Glas gleichmäßig beschichten. Durch einen automatisierten Wechsel des Targets von Hafnium zu Titan und umgekehrt kann ein Multilagensystem aus Hafniumoxid- und Titanoxideinzelschichten kontrolliert abgeschieden werden.

### Abbildungslegende

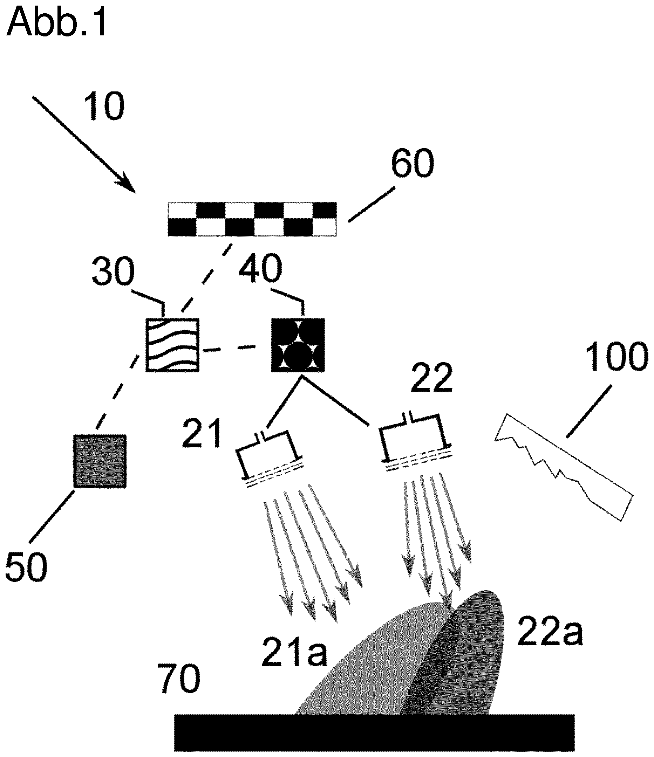

Abb. 1 Schematische Darstellung der erfindungsgemäßen Vorrichtung 10 zur Beschichtung eines Objektes 100, wobei das gezeigte Erfassungsmittel 50 und das Eingabemittel 60 optional sind.

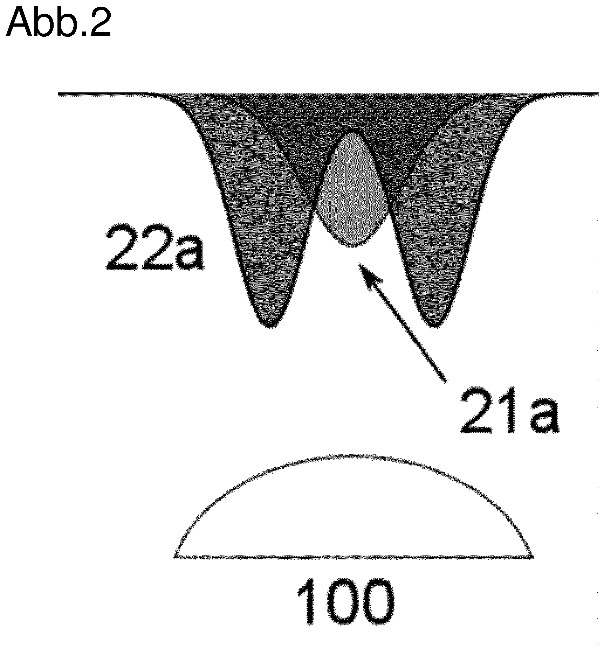

Abb. 2 Schematische Darstellung der Überlagerung der Profile der Sekundärplumes 21a,22a der Ionenquellen 21,22 zum Erzielen einer homogenen Beschichtung eines Objektes 100.

### Bezugszeichenliste

10 Vorrichtung zur Sputter-Deposition Beschichtung
21, 22 lonenquelle (21a,22a zugehörige Sekundärplumes)
30 Auswertemittel
40 Steuerungsmittel
50 Erfassungsmittel
60 Eingabemittel
70 Target
100 zu beschichtendes Objekt

## Patentansprüche

1. Verfahren zur Sputter-Deposition-Beschichtung von mindestens einem Objekt beliebiger Geometrie umfassend die folgenden Schritte:
• A Erfassung der Form der zu beschichtenden Oberfläche und Übermittlung der resultierenden Oberflächendaten an ein Auswertemittel
• B Eingabe des Zielschichtdickenprofils und Übermittlung des Zielschichtdickenprofils an ein Auswertemittel
• C Berechnung eines Bestrahlungsplans mit dem notwendigen Gesamtstrahlprofil mittels eines Auswertemittels, sodass die resultierende Massendichteverteilung des Beschichtungsmaterials das Zielschichtdickenprofil aus Schritt B aus den in Schritt A erfassten Oberflächendaten ergibt und Übermittlung des Bestrahlungsplans an ein Steuerungsmittel
• D Einstellung von wenigstens zwei lonenquellen zur Erzeugung des notwendigen Gesamtstrahlprofils zur Durchführung des Bestrahlungsplans aus Schritt C.
• E Durchführung der Beschichtung der zu beschichtenden Oberfläche ausgehend vom Bestrahlungsplan aus Schritt C und der Einstellung der lonenquellen aus Schritt D.

2. Vorrichtung (10) zur Durchführung des Verfahrens gemäß Anspruch 1 **dadurch gekennzeichnet, dass** diese wenigstens umfasst:
• zwei Ionenquellen (21,22) zur Bereitstellung der für die Beschichtung notwendigen Ionen in den Sekundärplumes (21a,22a) von mindestens einem Target (70)
• ein Auswertemittel (30) zum Empfang und (Zwischen-)speicherung der Oberflächendaten aus Schritt A und der Daten des Zielschichtdickenprofils aus Schritt B zusammen mit den Daten über mögliche Strahlprofile der wenigstens zwei Ionenquellen (21,22), sowie zur Erstellung eines Bestrahlungsplan aus diesen Daten im Rahmen des Schrittes C und zur Weiterleitung des erstellten Bestrahlungsplans an eine Steuerungsmittel (40) und
• ein Steuerungsmittel (40) zur Steuerung der wenigstens zwei lonenquellen (21,22)

3. Vorrichtung (10) gemäß Anspruch 2 **dadurch gekennzeichnet, dass** diese weiterhin ein Erfassungsmittel (50) zu Erfassung der Oberflächendaten der zu beschichtenden Oberfläche und zur Übertragung der Oberflächendaten an das Auswertemittel (30) zur weiteren Verarbeitung, umfasst.

4. Vorrichtung (10) gemäß Anspruch 2 oder 3 **dadurch gekennzeichnet, dass** diese weiterhin ein Eingabemittel (60) umfasst zur Eingabe der Daten des Schichtdickenprofils aus Verfahrensschritt B und/oder der Daten über mögliche Strahlprofile der wenigstens zwei Ionenquellen (21,22).
